# EUROPEAN PATENT APPLICATION

(11) **EP 4 131 422 A1**
(43) Date of publication of application: **08.02.2023**
(21) Application number: 21189495.1
(22) Date of filing: 03.08.2021
(51) Int. Cl.: H01L 29/78, H01L 29/06, H01L 29/40

(54) **SEMICONDUCTOR DEVICE**

(71) Applicant: Infineon Technologies Austria AG, 9500 Villach (AT)
(72) Inventor: BRAZ, Cesar Augusto, 9500 Villach (AT); NEUMANN, Ingmar, 9500 Villach (AT); FINNEY, Adrian, 9500 Villach (AT)
(74) Representative: JENSEN & SON

(57) **Abstract**

In an embodiment, a semiconductor device is provided that comprises a semiconductor body comprising an active area, wherein the active area comprises a plurality of active transistor cells, each active transistor cell comprising a columnar trench comprising a field plate and a mesa, and an edge termination region that laterally surrounds the active area. The edge termination region comprises a transition region that laterally surrounds the active region and an outer termination region that laterally surrounds the transition region. The edge termination region further comprises a plurality of inactive cells arranged in the transition region and in the outer termination region, each inactive cell comprising a columnar termination trench comprising a field plate and a termination mesa comprising a drift region of a first conductivity type. In the transition region, the termination mesa comprises a body region of the second conductivity type arranged on the drift region and in the outer termination region the drift region of the termination mesa extends to the first surface. The edge termination region further comprises at least one continuous trench that is positioned in the outer termination region and that laterally surrounds the columnar termination trenches and is filled with at least one dielectric material.

## Description

### BACKGROUND

Transistor devices used in power electronic applications are often fabricated with silicon (Si) semiconductor materials. Common transistor devices for power applications include Si CoolMOS^{®}, Si Power MOSFETs and Si Insulated Gate Bipolar Transistors (IGBTs).

A transistor device for power applications may be based on the charge compensation principle and may include an active cell field including a plurality of trenches, each including a field plate for charge compensation. In some designs, the trenches and the mesas that are formed between adjacent trenches each have an elongate striped structure. In some other designs, the trenches have a columnar needle-like shape, as for example disclosed in DE 10 2014 112371 A1. Typically, the active cell field of the transistor device is laterally surrounded by an edge termination structure which serves to avoid breakdown of the semiconductor device due to edge effects and to improve the performance of the device.

Avalanche breakdown is the phenomenon of current multiplication when a semiconductor device is subject to high electric fields. In the avalanche state, a high amount of power may be dissipated in the transistor device which may finally result in a destruction due to overheating if the avalanche current prevails longer than the time it takes to reach the thermal limit to overheat the transistor device. In order to prevent damage to the transistor device, it is desirable that the avalanche breakdown occur over a large area, thereby reducing the avalanche current density.

Discontinuities at the edges of semiconductor devices create locally large electric fields, tending to produce avalanche breakdown preferentially at the edge instead of uniformly distributed over the entire active area of the device. Edge termination structures are designed and fabricated to remove or smooth the discontinuities at the edge, thereby reducing the otherwise large fields at that location.

Avalanche breakdown can occur in the cell field. If the voltage required to reach breakdown electric field is lower for one device region, e.g. in a group of cells, than for others, the critical temperature will be reached more easily causing the device to fail in one specific area. To increase avalanche robustness, the avalanche current should be shared among many cells evenly.

Further improvements would be desirable to further improve the performance of transistor devices, including MOSFET devices, to achieve improved avalanche robustness and a low on-state resistance.

### SUMMARY

According to the invention, a semiconductor device is provided that comprises a semiconductor body comprising an active area and an edge termination region that laterally surrounds the active area. The active area comprises a plurality of active transistor cells, each active transistor cell comprising a columnar trench comprising a field plate and a mesa. The edge termination region comprises a transition region that laterally surrounds the active region and an outer termination region that laterally surrounds the transition region. The edge termination region further comprises a plurality of inactive cells arranged in the transition region and in the outer termination region, each inactive cell comprising a columnar termination trench comprising a field plate and a termination mesa comprising a drift region of a first conductivity type. In the transition region, the termination mesa comprises a body region of the second conductivity type arranged on the drift region and in the outer termination region the drift region of the termination mesa extends to the first surface.

The edge termination region further comprises at least one continuous trench that is positioned in the outer termination region. The at least one continuous trench laterally surrounds the columnar termination trenches and is filled with at least one dielectric material.

A columnar or needle-shaped trench has a small or narrow circumference or width in proportion to its height / depth in the substrate, as opposed to the continuous trench which is as a length in a plane parallel to the first surface that is greater than its depth in the substrate, that it perpendicular to the first surface.

The columnar termination trenches may be arranged in an array, for example in rows and columns, the array having a ring form and surrounding an array of columnar trenches in the active area. The at least one continuous trench laterally surrounds the array of columnar termination trenches and consequently laterally surrounds the plurality of inactive cells in the edge termination region. The continuous trench(es) are positioned laterally outside and peripheral to the columnar termination trenches.

In some embodiments, the continuous trench is free of electrically conductive material and, therefore, does not include a field plate.

The continuous trench continuously and uninterruptedly laterally surrounds the columnar trenches and has an enclosed annular or ring form in plan view. The continuous trench may have a rectangular or square annular form in plan view and its path in plan view may in addition include a bend, for example, such that the trench extends on two sides of a gate pad positioned at a corner of the semiconductor body or three sides of a gate pad positioned intermediate the length of a side face of the semiconductor body.

In some embodiments, the dielectric material in the continuous trench has a dielectric constant εr which is lower than the dielectric constant of silicon.

In some embodiments, the continuous trench extends through the buried doped region such that the buried doped region forms a portion of the opposing side walls of the continuous trench.

In some embodiments, the edge termination region further comprises a buried doped region of the second conductivity type that has a lateral extent such that it is positioned in the transition region and in the outer termination region.

In some embodiments, the buried doped region comprises an inner edge that is positioned under the body region in the transition region and an outer edge that is positioned laterally outside of the continuous trench and the plurality of inactive cells in the outer termination region. In some embodiments, the outer edge is positioned laterally between a side face of the semiconductor body and the continuous trench or in the case of more than one continuous trench between a side face of the semiconductor body and the laterally outermost one of the continuous trenches.

In some embodiments, in the transition region, the buried doped region is vertically spaced apart from the body region of the termination mesa by a portion of the drift region.

In some embodiments, in the transition region, the body region of the termination mesas extends to the first surface.

In some embodiments, the columnar trenches in the active area and in the edge termination region have a base positioned at a depth d from the first surface. In some embodiments, the buried doped region is positioned at a depth d_{buried} from the first surface, wherein 0.6 µm ≤ dburied ≤ 2.0 µm.

In some embodiments, the dielectric material in the continuous trench comprises portions of differing composition.

In some embodiments, the dielectric material in the continuous trench is in the solid state and the continuous trench is entirely filled with the dielectric material in the solid state.

In some embodiments, the dielectric material comprises at least one dielectric layer that lines sidewalls and a base of the continuous trench.

In some embodiments, the at least one dielectric layer surrounds a gap positioned in the continuous trench. In some embodiments, the at least one dielectric layer surrounds an enclosed cavity or void positioned in the continuous trench.

In some embodiments, the dielectric material comprises a first dielectric layer and a second dielectric layer arranged on the first dielectric layer.

In some embodiments, the dielectric material on the sidewalls of the continuous trench that is provided by the first and second dielectric layers has a total thickness t and the first dielectric layer is thinner that the second dielectric layer.

In some embodiments, the first dielectric layer comprises 20% to 75% of the total thickness t and the second dielectric layer comprises 25% to 80% of the total thickness t. In some embodiments, the first dielectric layer comprises 20% to 50% of the total thickness t and the second dielectric layer comprises 50% to 80% of the total thickness t.

In some embodiments, two or more layers of silicon oxide are formed on the side walls and base of the continuous trench. In some embodiments, the first dielectric layer is a thermally grown SiOₓ layer and the second dielectric layer is a TEOS (Tetraethylorthosilicate) layer. The second layer is, therefore, formed by deposition.

In some embodiments, the second dielectric layer is thinner than the first dielectric layer.

In some embodiments, the continuous trench is spaced apart from an outermost columnar termination trench by a distance dₒᵤₜₑᵣ and 50 nm ≤ dₒᵤₜₑᵣ ≤ 2 µm.

The distance dₒᵤₜₑᵣ may be selected depending on the blocking voltage of the semiconductor device. A wider spacing simplifies manufacturing by reducing silicon stress. Higher voltage classes have higher resistivity of the epitaxial layer which allows a wider spacing and less silicon stress.

In some embodiments, the semiconductor device has a blocking voltage of 220 V and the continuous trench is spaced apart from an outermost columnar termination trench by a distance dₒᵤₜₑᵣ and 900 nm ≤ dₒᵤₜₑᵣ ≤ 1100 nm.

In some embodiments, the semiconductor device has a blocking voltage of 150 V and the continuous trench is spaced apart from an outermost columnar termination trench by a distance dₒᵤₜₑᵣ and 300 nm ≤ dₒᵤₜₑᵣ ≤ 700 nm.

In some embodiments, the semiconductor device has a blocking voltage of 60 V and the continuous trench is spaced apart from an outermost columnar termination trench by a distance dₒᵤₜₑᵣ and 100 nm ≤ dₒᵤₜₑᵣ ≤ 200 nm.

In some embodiments, the semiconductor device has a blocking voltage of 40 V and the continuous trench is spaced apart from an outermost columnar termination trench by a distance dₒᵤₜₑᵣ and 50 nm ≤ dₒᵤₜₑᵣ ≤ 150 nm.

The semiconductor body typically has a cuboid form with substantially perpendicular, substantially straight side faces, i.e. perpendicularly to the side faces, that intersect at corners. The distance dₒᵤₜₑᵣ is measured adjacent to the side faces rather than at the corners, i.e. diagonally from the corner.

In some embodiments, each mesa of the active transistor cells comprises a drift region of a first conductivity type, a body region of a second conductivity type opposing the first conductivity type arranged on the drift region, a source region of the first conductivity type arranged on the body region and a gate trench comprising a gate electrode. The gate trench extends through the source region and the body region into the drift region. Each of the columnar trenches in the active area extends from the first surface through the body region and into the drift region.

In some embodiments, the semiconductor device further comprises at least one gate finger extending over the edge termination region to a gate runner that is positioned laterally between the side face of the semiconductor body and the continuous trench in the outer termination region.

In some embodiments, the semiconductor device further comprises a gate contact that electrically coupling the gate runner to gate electrodes of the active transistor cells. The gate contact is positioned above the body region in the transition region.

In some embodiments, the buried doped region forms a portion of side walls of at least two rows of columnar termination trenches. In some embodiments, the buried doped region further forms a portion of side walls of the continuous termination trench or trenches.

In some embodiments, the gate runner is positioned laterally between the side face and an outer edge of the buried doped region.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 illustrates a top view of a semiconductor device.
Figure 2 illustrates a cross-sectional view of a portion of the semiconductor device of figure 1.
Figure 3A illustrates a cross-sectional view of an edge termination trench according to an embodiment.
Figure 3B illustrates a cross-sectional view of an edge termination trench according to an embodiment.
Figure 3C illustrates a cross-sectional view of an edge termination trench according to an embodiment.
Figure 3D illustrates a cross-sectional view of an edge termination trench according to an embodiment.
Figure 4 illustrates a cross-sectional view of a semiconductor device according to an embodiment.
Figure 5 illustrates a top view of a portion of the semiconductor device of figure 4.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The Figures illustrate relative doping concentrations by indicating "-" or "+" next to the doping type "n" or "p". For example, "n⁻" means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

A transistor device is optimized for switching applications and typically has a voltage rating indicating the voltage at which the transistor device may be safely operated. When the transistor device is off, it is capable of blocking a certain voltage, such as 100V, 120V or 150V, known as the blocking voltage or BVDSS for a particular drain source current (I_{DS}). When the transistor device is on, it has a sufficiently low on-resistance (RON) for the application in which it is used, i.e. it experiences sufficiently low conduction loss when a substantial current passes through the device.

Some types of transistor device, such as a MOSFET, include a cell field comprising a plurality of substantially identical transistor cells, each having a transistor structure. The cells are electrically connected to form a single transistor device for switching. The cell field provides the active area of the transistor device within the semiconductor die in which the transistor device is formed. The transistor device includes an edge termination region that laterally surrounds the cell field and that has a structure that serves to reduce the peak lateral electric field between the cell field and the side faces of the transistor device, i.e. the side faces of the semiconductor die, to avoid breakdown of the semiconductor device due to edge effects and to improve the performance of the device.

A Power MOSFET with improved avalanche robustness and a low on resistance is provided. According to the invention, a termination structure is provided for a semiconductor device, in particular a transistor device, that is compact and easily introduced into existing manufacturing processes. The transistor device may be a Field Effect Transistor device and include columnar trenches, each including a field plate, as a charge compensation structure. At least one edge termination trench that is filled with dielectric material and that continuously and uninterruptedly surrounds the cell field is provided. The continuous edge termination trench may replace some or all of the edge termination trenches that include conductive material and a field plate that is electrically coupled to source potential. The edge termination trenches have a columnar or needle shape, whereas the continuous trench has an elongate form that forms a continuous shape in plan view, e.g. an annular or ring shape.

In some embodiments, the edge termination region also comprises a buried doped region which is doped with the opposing conductivity type from the conductivity type of the drift region of the transistor device. The continuous trench may extend through the buried doped region. The spacing of the continuous trench from the active area of the device can be increased by adding such a counter doping implant. This has been found to be beneficial at lower voltage classes. The counter doping implant may be used to increase the process window and to allow the dielectric filled continuous trench to be spaced much further away from the columnar termination trenches. This enables the stress that is caused by the inclusion of the dielectric filled continuous trench in the edge termination region and that is transferred to the active area of the transistor device to be reduced or even eliminated.

The edge termination structure moves avalanche breakdown into the active cell area greatly improving the avalanche performance. As it is not necessary to alter the design of the active transistor cells to provide an effective termination structure, the transistor cell structure can be optimized to achieve better Ron.Area and switching characteristics. As the edge termination structure is small, a larger active area and, therefore, a better Ron.Area is achieved. Additionally, no unnecessary termination capacitance is introduced, thus improving Qoss. The combination of the continuous dielectric filled trench and buried doped layer in the edge termination region has the effect of reducing the on-state resistance and improving the avalanche ruggedness of the transistor device.

In some embodiments, the continuous edge termination trench includes two or more dielectric materials. In some embodiments, other types and combinations of dielectric material, such as nitride, oxynitride or even vacuum/ gas gap trenches are used. In some embodiments, a dielectric solid material, such as an oxide and/or nitride is used that lines the sidewalls and base of the trench and surrounds a void or cavity formed at the centre of the trench. This design of the continuous edge trench is effective in preventing the introduction of stress and Idss leakage.

In some embodiments, the continuous trench or trenches are filled by at least two different types of dielectric material, for example a thermally grown oxide in order to provide a high-quality interface between Si and oxide, and a deposited oxide such as TEOS, which is used to adjust the mechanical properties of the structure. When using the TEOS layer in order to close the trench, a small void can be formed in the oxide trench because the TEOS tends to deposit somewhat thicker at the upper sidewall. The resulting void helps to relax the stress further.

In some embodiments, two or more continuous trenches that are arranged concentrically may be used to further increase avalanche ruggedness. For multiple trenches, each additional trench may have a similar spacing from its neighbour to the spacing between the innermost continuous trench and the outermost columnar edge termination trench.

The edge termination region as described herein can used for medium voltage power MOSFETs with a blocking voltage in the range of 60V to around 300V, and for needle field plate power MOSFETs. These types of MOSFETs may be used in applications such as E-fuses, LV Drives and synchronous rectification.

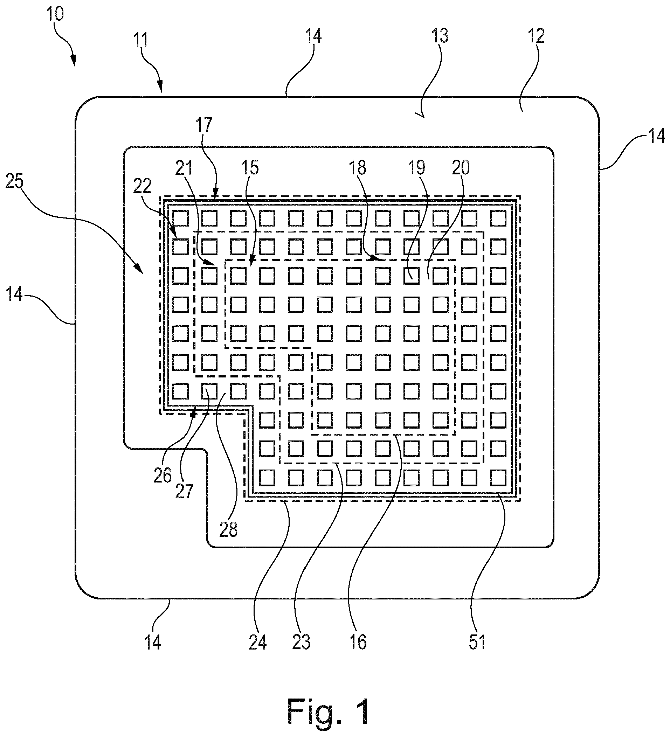

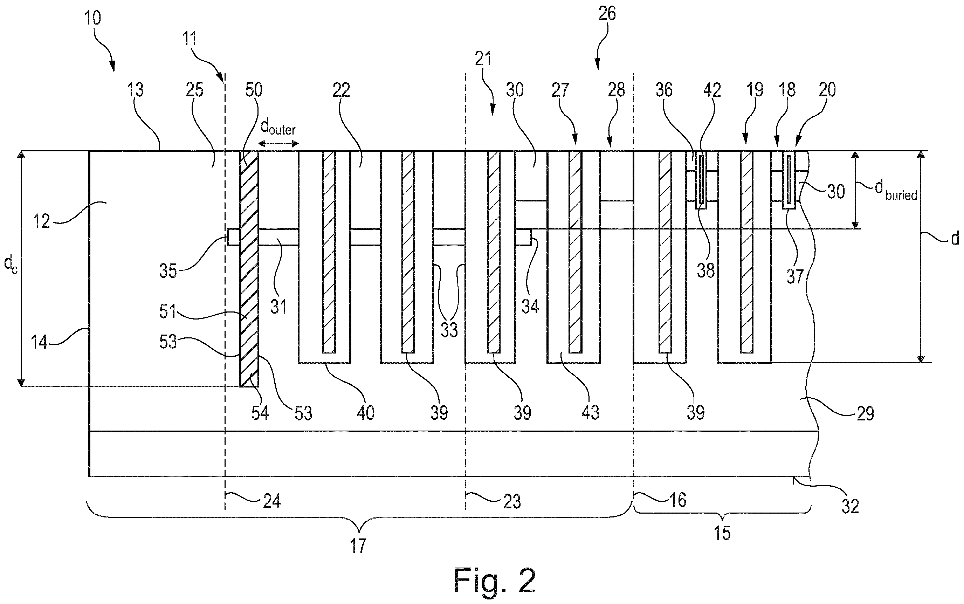

Figure 1 illustrates a top view of a semiconductor device 10 which includes a transistor device 11 and Figure 2 illustrates a cross-sectional view of a portion of the semiconductor device 10 of figure 1.

The transistor device 11 may be a vertical field effect transistor device based on a charge compensation principle. The semiconductor device 10 includes a semiconductor body 12 having a first surface 13, a second surface 32, which cannot be seen in the top view of figure 1, that opposes the first surface, and side faces 14 extending between the first surface 13 and the second surface 32. The semiconductor body 12 may comprise silicon and may include a silicon epitaxial layer deposited on a substrate such as a single crystal silicon substrate. The first surface 12 can be referred to as the top surface and the second surface as the rear surface.

The semiconductor device 10 includes an active area 15 which is denoted by the dashed line 16 in the plan view of figure 1. The active area 15 is laterally surrounded by an edge termination region 17. The edge termination region 17 laterally surrounds the active area 15 on all sides. The edge termination region 17 includes an edge termination structure for avoiding breakdown of the semiconductor device 10 at or near the first surface 13 and for increasing the breakdown voltage of the semiconductor device 10. The edge termination structure may, for example, lower the field intensity junction by spreading the electric field lines across the edge termination region 17.

The active area 15 includes a plurality of active transistor cells 18. Each active transistor cell 18 comprises a columnar trench 19 which comprises a field plate 39 and a mesa 20. The mesas 20 are formed by the regions of the semiconductor body 12 that are located between the columnar trenches 19. The mesas 20 include a drift region 29 of the first conductivity type.

The columnar trenches 19 may be arranged in an array, such as a regular array, such as a regular grid, for example rows and columns, or may be arranged in an array of staggered or shifted rows, in which the columnar trenches 19 of each row have the same pitch or spacing in the long direction of the row and are offset in the long direction with respect to an immediately adjacent row of the array. In some embodiments, the columnar trenches 19 are arranged in an array in which the columnar trenches have a regular pattern such as a hexagonal place packed arrangement. The lateral form of each of the columnar trenches 19 within the array having any form or pattern may be square, octagonal, round or hexagonal, for example. For example, the columnar trenches may have a lateral octagonal form in plan view and be arranged in staggered rows.

The edge termination region 17 comprises a transition region 21 which laterally surrounds the active region 15 and an outer termination region 22 which laterally surrounds the transition region 21 and an outer region 25 that laterally surrounds the outer termination region 22. The boundary between the transition region 21 and the outer termination region 22 is indicated by the dashed line 23 and the boundary between the outer termination region 22 and the outer region 25 is indicated by the dashed line 24 in figures 1 and 2.

The transistor device 11 may be a vertical MOSFET device that comprises a field plate 39 for charge compensation. The source and gate of the MOSFET device are positioned at the first surface 13 and the drain is positioned at the second opposing surface so that the drift path of the MOSFET device extends vertically and substantially perpendicular to the first surface 13 and the second surface 32. MOSFET devices with a field plate for charge compensation offer an improvement of the area-specific resistance. Some of these devices use a stripe design, i.e. the trenches and the mesas have an elongate strip form and are arranged alternatively so that a strip-like mesa is defined by two adjacent strip-like trenches. However, some types of designs of MOSFET devices with a field plate for charge compensation, such as those described herein, include columnar or needlelike trenches 19 so that the mesa 20 is formed by the material between the columnar trenches 19.

A columnar field plate 39 is positioned in the columnar trenches 19 and is electrically insulated from the semiconductor body 12 by a dielectric material 43 that lines the sidewalls 33 and base 40 of the columnar trench 19. The columnar trench 19 is typically a deep trench containing the field-plate 39 in the center. A separate shallower gate trench 37 is positioned in the mesa 20. The gate electrode 38 of the transistor cell 18 is positioned in the gate trench 27. The gate trench 37 has an elongate form. This design results in a larger cross section of the mesa region 20 which is expected to lead to a further reduction of the overall on-resistance.

In some embodiments, the gate trenches 37 have a strip-like form and extend substantially parallel to one another. One gate trench 37 is positioned adjacent two opposing sides of the columnar trench 19. In some embodiments, the gate trenches 37 interconnect to form a grid structure that laterally surrounds each columnar trench 19.

The transition region 21 and the outer transition region 22 of the edge termination region 17 comprise a plurality of inactive cells 26. Each inactive cell 26 comprises a columnar termination trench 27 and a termination mesa 28. The columnar termination trench 27 also comprises a field plate 39. The termination mesa 28 includes a drift region of a first conductivity type.

The edge termination region 17 further includes at least one continuous trench 50 that is positioned in the outer termination region 22. The continuous trench 50 is filled with dielectric material and laterally surrounds the columnar termination trenches 27. The continuous trench 50 continuously and uninterruptedly laterally surrounds the columnar termination trenches 27 and the inactive cells 26. The columnar termination trenches 27 and the columnar trenches 19 of the active cells 18 may be arranged in an array, for example a grid of rows and columns. The continuous trench 59 laterally surrounds and is arranged at the periphery of this array, i.e. between the array of columnar edge termination trenches 27 and the side faces 14 of the semiconductor body 12. The continuous trench 50 is free of electrically conductive material and does not include a field plate.

In some embodiments, the continuous trench 50 is spaced apart from a laterally outermost one of the columnar termination trenches 27 by a distance dₒᵤₜₑᵣ. dₒᵤₜₑᵣ may be 50 nm ≤ dₒᵤₜₑᵣ ≤ 2 µm. The semiconductor body 12 typically has a cuboid form with substantially perpendicular substantially straight side faces 24 that intersect at corners. The distance dₒᵤₜₑᵣ is measured adjacent to the side faces 24 rather than at the corners.

In some embodiments, the lateral shape, pattern and pitch (centre-to-centre spacing) of the columnar termination trenches 27 may be the same as that for the columnar trenches 19 of the active transistor cells 17 of the active area 15. The field plates in the columnar termination trenches 27 and in the columnar trenches 19 may be of the same size and shape.

In some embodiments, some or all of the termination mesas 28 are laterally smaller than the mesas 20 in the active region 15. This smaller width of the termination mesas 28 may be the result of the columnar termination trenches 27 having the same centre-to centre spacing or pitch, but each columnar termination trenches 27 being laterally wider than the columnar trenches 19 in the active region 15.

However, in other embodiments, some or all of the termination mesas 28 are laterally wider than the mesas 20 in the active region 15.

In some embodiments, the termination mesas 28 and columnar termination trenches 27 which are positioned laterally nearer to the active region 15 have the same width as the mesas 20 and columnar trenches 19, respectively, in the active area 15, whereas the termination mesas 28 which are positioned laterally more outwardly from the active area 15 are laterally smaller, e.g. narrower, than the mesas 20 in the active area 15 and the columnar termination trenches 27 which are positioned laterally more outwardly from the active area 15 have a greater lateral size, e.g. width, than the columnar trenches 19 in the active area 15.

In some embodiments, the doping level of the drift region 29 in the narrower termination mesas 28 is higher than the doping level of the drift region 29 in the mesas 20 in the active area 15 and in the wider termination mesas 28.

In some embodiments, the columnar termination trenches 27 and the columnar trenches 19 in the active region 15 have the same depth, i.e. have a base or bottom that is positioned at approximately the same distance from the first surface 13. In other embodiments, the columnar termination trenches 27 in the transition region 21 and outer transition region 22 have a greater depth than the columnar trenches 19 in the active region 15.

Figures 2 illustrates a cross-sectional view of a portion of the semiconductor device 10 and illustrates a portion of the active area 15 and the edge termination region 17 including the transition region 21, the termination region 22 and the outer region 25.

In the active area 15, the mesas 20 comprise the drift region 29 of a first conductivity type, a body region 30 of a second conductive type that opposes the first conductivity type that is arranged on the drift region 30 and a source region 39 of the first conductive type that is arranged on the body region 30 and that extends to the first surface 13. The source region 39 is more highly doped that the drift region 29. For example, in some embodiments, the first conductivity type is n-type and the second conductivity type is p-type or vice versa.

In the transition region 21, the termination mesa 28 comprises a body region 30 of the second conductivity type that is arranged on the drift region 29. In the transition region 21, the body region 30 extends to the first surface 13 of the semiconductor body 12 so that no source region is provided. These cells are, therefore, inactive.

In the outer termination region 22, the drift region 29 of the termination mesas 28 extends to the first surface 13 of the semiconductor body 12. The termination mesas 28 in the outer termination region 22, in contrast to the termination mesas 28 in the transition region 21, do not include a body region.

The transition region 21 is distinguishable from the outer termination region 22 by the presence of the body region 30. The region of the semiconductor body 12 that is doped with the first conductivity type and provides the source region 36 is laterally smaller than the region of the semiconductor body that is doped with the second conductivity type and that forms the body region 30. The lateral extent of the body region 30, as defined by the outer edge of the body region 30, is less than the lateral extent of the drift region 29 and the first surface 13.

The outer termination region 25 that surrounds and, in particular, is contiguous with the outer termination region 22 is free of inactive cells. Therefore, the outer termination region 25 is free of columnar trenches and mesas. The outer termination region 25 may include semiconductor material of the first conductivity type.

The mesas 20 of the active cells 18, the termination mesas 28 of the inactive cells 26 of the transition region 21 and of outer termination region 22 of the edge termination region 17 include the drift region 29 comprising a first conductivity type. The drift region 29 and the outer termination region 25 may be formed from an epitaxial silicon layer.

The at least one continuous trench 50 is positioned in the outer termination region 22 and laterally surrounds the array of columnar termination trenches 27. The continuous trench 50 is filled with at least one dielectric material. In contrast to the columnar termination trenches 27, the continuous trench 50 is free of electrically conductive material and, therefore, free of a field plate. The continuous trench 50 has side walls and a base 54 that is positioned at a depth d_{c} from the first major surface 13. The depth d_{c} may be substantially the same as the depth d of the columnar trenches 19, 27 or may be less than or greater than the depth d. The depth d_{c} of the continuous trench 50 is, however, greater than the depth d_{g} of the gate trench 37.

The dielectric material 51 positioned in the continuous trench 50 has a dielectric constant εr which is lower than the dielectric constant of silicon which has εr of 11.7. Possible dielectric materials for the continuous trench 50 include SiO₂ with εr around 2.66, a vacuum with εr of 1.0 and silicon nitride with εr of around 6.0.

In some embodiments, such as that illustrated in figure 2, the edge termination region 17 further comprises a buried doped region 31 which can be seen in the cross-sectional view of figure 2. The buried doped region 31 has a lateral extent such that it is positioned in both the transition region 21 and in the outer termination 22 of the edge termination region 17. The buried doped region 31 comprises the second conductivity type. The continuous trench 50 extends through the buried doped region 31. The buried doped region 31 extends between the sidewalls 33 of at least some of the columnar termination trenches 27 and the continuous trench 50. The buried doped region 31 forms a portion of the sidewalls 33 of at least some of the columnar termination trenches 27 and a portion of the two opposing elongate side walls 53 of the continuous trench 50.

The buried doped region 31 is positioned within the semiconductor body 12 at a distance from the first major surface 13 and has the form of a single doped region. The buried doped region 31 may have a substantially uniform thickness. The buried doped layer 31 may have the form of a plate-like layer that is bounded above and below by portions of the drift region 29 and that is spaced apart from the first major surface 13 and from the second major surface. This plate-like buried doped layer may also have a uniform thickness. In some embodiments, the buried doped layer 31 may be spaced apart from the body region 30 by a portion of the drift region 29.

In some embodiments, a portion of the buried doped layer 31 is spaced apart from the body region 30 by a portion of the drift region 29 and vertically overlaps a portion of the body region 30.

The buried doped layer 31 is doped with the second conductivity type, e.g. p-type, whereas the drift region 19 is doped with the first conductivity type, e.g. n-type. The buried doped layer 31 can be considered to provide a counter doping layer. In some embodiments, the doped buried layer has a doping concentration of 1e14-1e17/cm³ which may be produced from an implant of 1e11 - 1e13/cm² and the drift region a doping concentration of 1e14-1e17/cm³.

The lateral extent of the buried doped layer 31 may be defined by an inner edge 34 and an outer edge 35. In some embodiments, the buried doped region 31 comprises an inner edge 34 that is positioned in the transition region 21 of the edge termination region 17 and is positioned under the body region 30 of the termination mesa 28. The buried doped region 31 is vertically spaced apart from the body region 30 of the termination mesa 28 by a portion of the drift region 29. In some embodiments, the inner edge of the buried doped region 31 may be arranged such that the buried doped region 31 is positioned underneath the body region 30 that is positioned in two or more neighbouring termination mesas 28.

In at least some of the transition region 21, the body region 30 does not vertically overlap with the buried doped region 31. In particular, the portion of the body region 30 that is laterally positioned nearer to the active area 15 does not vertically overlap with the buried doped region 31. The inner edge 34 of the buried doped region 21 is laterally spaced apart from the active area 15 by at least one inactive cell 26 including a columnar termination trench 27 and termination mesa 28. In some embodiments, one or more termination mesas 28, which are laterally contiguous to the active region 15, have a structure such that the drift region 29 extends without interruption to the body region 30 and are free of the buried doped region 31.

In some embodiments, the buried doped region 31 has an outer edge 35 that is positioned in the outer region 25 of the edge termination region 17 so that the buried doped region 31 extends from within the transition region 21, over the entire width of the intermediately situated outer termination region 22 and into the outer region 25 which is free of inactive cells. The outer edge 35 of the buried doped region 31 is positioned laterally between the side face 14 of the semiconductor body 12 and the continuous trench 50. Thus, the continuous trench 50 extends through and interrupts the doped buried layer 31 such that the doped buried layer 50 forms a portion of the opposing side walls 53 of the continuous trench 50.

The buried doped region 31 forms a portion of the sidewalls of at least two laterally adjacent rows of columnar termination 27 trenches, whereby one row is positioned in the transition region 21 and the other row is positioned in the outer termination region 22, since the buried doped region 31 has a lateral extent such that it is positioned in both the transition region 21 and in the outer termination region 22 of the edge termination region 17.

The columnar trenches 17 arranged in the active area 15 and the columnar termination trenches 27 arranged in the edge termination region 17 extend from the first surface 13 into the semiconductor body 12 by a distance d such that the columnar trenches 17, 27 have a base or bottom positioned at a depth d from the first surface 13. The buried doped region 31 is, in some embodiments, positioned at a depth d_{buried} from the first surface, wherein 0.6 µm ≤ d_{buried} ≤ 2.0 µm. d_{buried} < d, the depth of the base 40 of the columnar trenches 19, 27 from the first major surface 13. Additionally, d_{buried} < d_{c}, the depth of the base 54 of the continuous trench 50 from the first major surface 13.

The buried doped region 31 may have the form of a continuous ring when viewed from above that is positioned laterally adjacent all sides of the active area 15 and continuously laterally surrounds the active area 15.

The doped buried region 31 may have the form of a layer having substantially uniform thickness. In some embodiments, the upper boundary of the buried doped region 31 is positioned at a depth d_{1buried} from the first surface and the lower boundary of the buried doped region 31 is positioned at a depth d_{2buried} from the first surface, whereby d_{2buried} > d_{1buried} and (d_{1buried} - d_{2buried}) is around 200nm to 800nm.

The buried doped region 31 may be used in order to counterdope the mesa epi and to realize a reduced area-specific on-resistance. In some embodiments, the buried doped region 31 extends in the area of the edge termination trenches 28 of the edge termination region 17 and from within the transition region 21, through the outer termination region 22 and into the outer region 25. The buried doped region 31 counterdopes the epitaxy of the opposition conductivity type in the termination region so that the combination behaves like high resistivity epitaxial layer. This means that the heavily doped epitaxial layer used in the active area to achieve a low resistance is effectively higher resistance in the termination region making it easier to support a higher voltage.

Extending the buried doped region 31 from the edge needle 39 until at least the oxide trench 50 counter dopes the intervening silicon. This allows the oxide trench 50 to be placed much further away from the edge needle 39. This reduces stress in this silicon region. It also widens the acceptable range of mesa widths improving manufacturing.

In some embodiments, this additional buried doped region 31 has the following combination of properties: it is fully depletable in order to locally relax the electric field, it laterally extends under the outer end of the body region 30 in the transition region 21 in order to avoid an early breakdown at the curvature at the end of the body region 30 and it extends laterally towards the side faces 14 of the semiconductor body 12 into the outer termination region 25, which includes no columnar trenches with field plates, in order to 'stretch' the potential lines at the outer side of the termination structure and to relax the electric field at the laterally outermost trench 27 of the edge termination region 17 so as to avoid an early breakdown at this location.

The combination of the continuous dielectric filled trench 50 and doped buried region 31 in the edge termination region 17 provides an edge termination structure that moves avalanche breakdown into the active cell area greatly improving the avalanche performance. As the edge termination structure is small, a larger active area and, therefore, a better Ron.Area is achieved. The transistor cell structure may be further optimized to achieve better Ron.Area and switching characteristics.

Referring to figure 2, each mesa 20 of the active transistor cells 18 comprises the drift region 29 of the first conductivity type, a body region 30 of the second conductivity type which is arranged on the drift region 29 and a source region 36 of the first conductivity type which is arranged on the body region 30. Each of the columnar trenches 19 of the active transistor cells 18 extends from the first surface 13 through the source region 36 the body region 30 and into the drift region 29.

Each mesa 20 of the active transistor cells 18 also includes a gate trench 37 comprising a gate electrode 38. The gate electrode 38 is electrically insulated from the mesa 20 by an insulating layer 42 which lines the side walls and base of the gate trench 37. The gate trench 37 extends through the source region 36 and the body region 30 to the drift region 29. The depth of the columnar trenches 19 from the first surface 13 is greater than the depth of the gate trench 37 from the first surface 13. The gate trench 37 is elongate having a length extending into the plane of the drawing. The gate trenches 37 may be arranged parallel to one another and be positioned on two opposing sides of the columnar trenches 19 or may interconnect to form a grid structure and be laterally positioned adjacent more than two sides or on all sides of the columnar trench 19.

The columnar trenches 19 of the active transistor cells 18 and the columnar termination trenches 27 of the edge termination region 17 each include a field plate 39 which is positioned towards the bottom of the columnar trench 19, 27, respectively. The field plate 39 is electrically insulated from the semiconductor body by an electrically insulative layer 43 which lines the sidewalls 33 and base 40 of the columnar trenches 19, 27.

As mentioned above, the continuous trench 50 may have different structures. In some embodiments, such as that illustrated in figures 1 and 2, the continuous trench 50 is entirely filled with a solid dielectric material 51, such as an oxide, e.g. silicon oxide, or a nitride. The continuous trench may be entirely filled with a single solid dielectric material 51 or with two or more solid dielectric materials of differing composition.

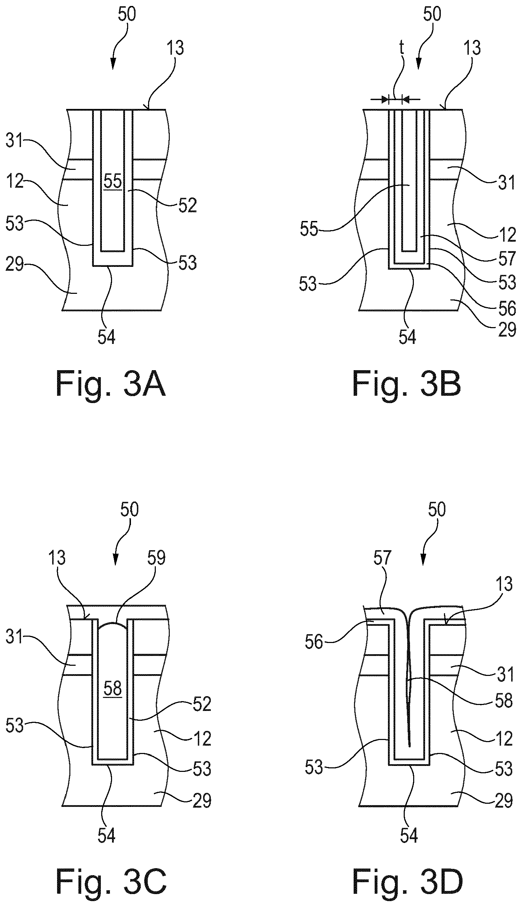

Figure 3, which includes figures 3A to 3D, illustrates cross-sectional views of three alternative structures for the continuous trench 50.

In some embodiments, the dielectric material 51 in the continuous trench 50 comprises portions of differing composition.

Figure 3A illustrates an embodiment in which the dielectric material 51 comprises a dielectric layer 52 that lines sidewalls 53 and a base 54 of the continuous trench 50. The dielectric layer 52 surrounds a gap or void 55 in at the centre of the continuous trench 50. The gap 55 may be filled with a vacuum or gas which itself is a dielectric material having a dielectric constant that is lower than the dielectric constant of silicon, i.e. lower than 11.7. The dielectric layer 52 may be formed of a single layer or two or more sublayers.

Figure 3B illustrates an embodiment in which the dielectric material 51 comprises a first dielectric layer 56 and a second dielectric layer 57 arranged on the first dielectric layer. The first dielectric layer 56 lines the side walls 53 and the base of the continuous trench 50. The second dielectric layer 57 may entirely cover the first dielectric layer 56. The first and second dielectric layers 56, 57 may surround a gap or void 55 at the centre of the trench. In other embodiments, the second dielectric layer 57 or a further dielectric layer may entirely fill the continuous trench 50.

In some embodiments, the dielectric material 51 on the sidewalls 53 of the continuous trench 50 has a total thickness t. In embodiments having two dielectric layers, the first dielectric layer 56 is thinner that the second dielectric layer 57.

In some embodiments, the first dielectric layer 56 comprises 20% to 75% of the total thickness t and the second dielectric layer 57 comprises 25% to 80% of the total thickness t. In some embodiments, the first dielectric layer 56 comprises 20% to 50% of the total thickness t and the second dielectric layer 57 comprises 50% to 80% of the total thickness t.

In some embodiments, the first dielectric layer 56 is a thermally grown SiOₓ layer and the second dielectric layer 57 is grown by deposition, for example by depositing a TEOS layer 57 on the thermally grown layer 56.

In some embodiments, the first dielectric layer 56 and the second dielectric layer 57 have different compositions, for example a silicon nitride and a silicon oxide. More than two dielectric layers may also be used. The two or more dielectric layers may be formed by deposition, or thermal growth or by a combination of thermal growth and deposition.

Figure 3C illustrates an embodiment in which the at least one dielectric layer 52 surrounds an enclosed cavity 58 positioned in the continuous trench 50. The enclosed cavity 58 is formed by capping the gap 55 formed at the centre of the trench and surrounded by the dielectric layer 52 on the sidewall 53 and base 54 of the continuous trench 50. The gap 55 may be capped or sealed by applying a dielectric cap 59 that may be formed by deposition of a dielectric layer. The dielectric layer may extend over the first major surface 13. A multi-layer dielectric layer 52 may also be used in place of the single dielectric layer 52 illustrated in figure 3C.

In embodiments including a gap or enclosed cavity, the gap or enclosed cavity may occupy a smaller volume of the continuous trench 50 than the dielectric material 51, for example less than 10 volume percent.

Figure 3D illustrates an embodiment of a structure of the continuous trench 50, in which two dielectric layers 56, 57 are formed on the side walls 53 and base 54 of the continuous trench that also extend over the first surface 13. The second dielectric layer 57 has a thickness and shape such that at the open end of the continuous trench 50 it fills the width of the trench 50 and such that lower down in the trench the second layer 57 on the opposing side walls 53 does not meet. The thickness of the dielectric layer 57 is, therefore, smaller towards the base 54 of the continuous trench 50 and greater at the open end of the continuous trench 50. Thus, a void or enclosed cavity 58 is formed lower down in the continuous trench 50 that is enclosed and defined by the second dielectric layer 57.

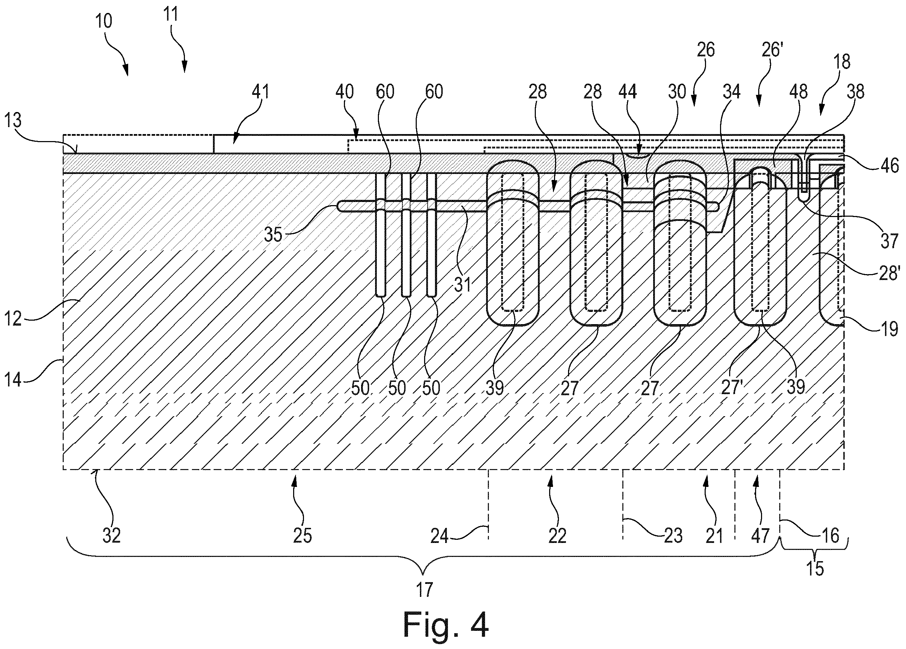

Referring to figure 4, in some embodiments, the edge termination region 17 comprise two or more continuous trenches 50 that are arranged concentrically such that they are spaced apart from one another by a continuous mesa 60. In figure 4, three continuous trenches 50 are shown. In some embodiments, the spacing between the continuous trenches 50, i.e. the width of the continuous mesa 60, may be substantially the same as the spacing dₒᵤₜₑᵣ between the laterally innermost continuous trench 50 and the laterally outermost columnar trench 27 as measured adjacent the side face 14 of the semiconductor body 12.

Referring to figure 4, in some embodiments, the edge termination region 17 further includes an inner transition region 47 that is formed at the boundary between the transition region 21 and the active region 15. This inner transition region 47 includes one or more rows of inactive cells 26' having a columnar termination trench 27' and a termination mesa 28'. The termination mesa 28' and associated columnar termination trench 27' has a body region 30 and does not have a source region so that the body region extends to and forms the first surface 13. The columnar termination trenches 27' in this inner transition region 47 are distinguished from the columnar termination trenches 27 of the transition region 21 by a body contact 48. The body contact 48 positioned in the columnar termination trench 27' is used to electrically couple the body region 30 to source potential.

The various regions of the semiconductor device 10 can be distinguished by the connections to the trenches. In the active area 15, the trenches 19 and associated mesa 20 includes a body region 30, a source region 36 on the body region. In the inner transition region 47, columnar termination trenches 27' and their associated termination mesa 28' have a body region 30, a body contact 48 and no source region. In the transition region 21, the columnar termination trenches 27 and associated termination mesa 28 have a body region 30, no body contact and no source region. In the outer transition region 22, the columnar termination trenches 27 and associated termination mesa 28 have no body region, no body contact and no source region.

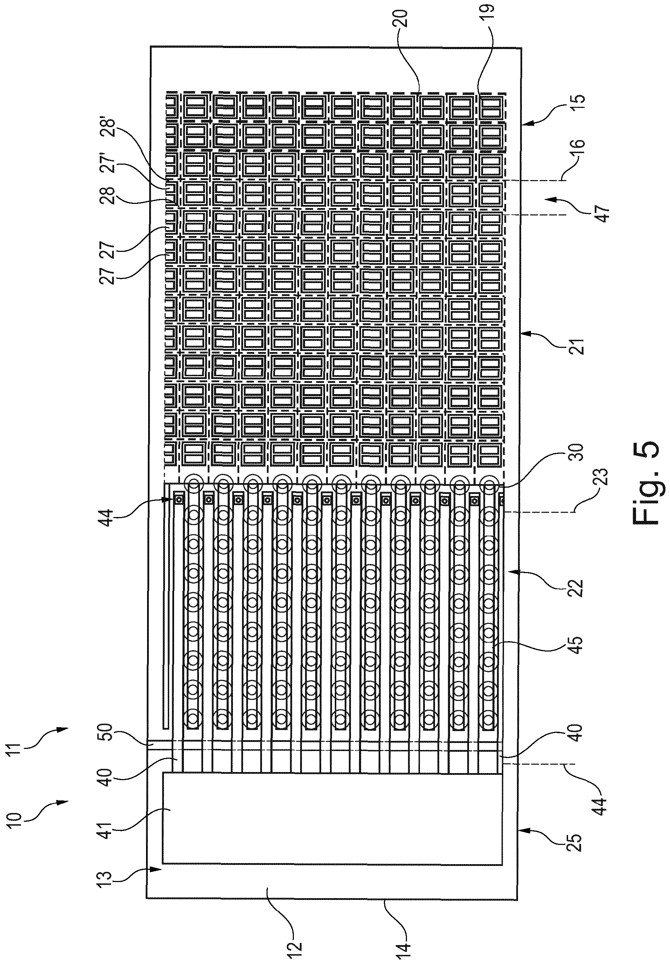

Figure 5 illustrates a top view of a portion of the semiconductor device 10 of figure 4, whereby the position of only one of the continuous trenches 50 is shown, and illustrates a portion of the active region 15, the transition region 21, the outer transition region 22 and outer termination region 25. Figure 5 also illustrates the metallisation structures which are electrically connected to the source region 36 of the active transistor cells 18 and the gate electrodes 38 of the active transistor cells 18.

In the plan view of figure 5, eight edge termination trenches 27 are illustrated. However, the design is not limited to eight termination trenches and may include more than or fewer than eight trenches. In practice, fewer than eight trenches are required in order to provide beneficial effects.

Figure 5 illustrates that the semiconductor device 10 further includes a gate runner 41 positioned on the first surface 13 in the outer region 25 of the semiconductor device 10 and at least one gate finger 40. The gate finger 40 and the gate runner may be comprised of metal. The gate runner 41 may be positioned laterally between and spaced apart from the side face 14 of the semiconductor body 12 and the outer edge 35 of the buried doped region 31. The gate runner 41 is positioned between the side face 14 of the semiconductor body 12 and the continuous trench 50 and, in embodiments including two or more continuous trenches, between the side face 14 of the semiconductor body 12 and the laterally outermost one of the continuous trenches 50. The gate fingers 40 extend from the gate runner, over the edge termination region 17 to a position within the transition region 21 where it is electrically coupled to the gate electrode 38 by a groove contact 44.

Source fingers 45, which are electrically coupled to the source regions 31 of the active transistor cells 18, are arranged alternately with the gate fingers 40. The gate contact 44, which may have the form of a groove, extends from the gate finger 40 which is electrically coupled to the gate electrodes 38 of active transition transistor cells 17. The gate contact 44 may be positioned above the body region 30 in the transition region 21. One or more insulation layers 46 are arranged on the body region 30 between the body region 30 and the gate finger 40.

The body region 30 of the semiconductor device 10 is arranged to extend from the active area 15 into the transition region 21 of the termination structure 17. This arrangement enables the contact from the gate finger 40 to the gate trench grid to be realized outside of the active area 15. The lateral width of the transition region 21, which is inactive as there is no source is present in the termination mesas 28, can be used to provide a minimum distance between the edge of the source region 36 within the active region 15 and the edge of the overlying source metal layer and a large enough distance to hinder potentially hazardous ion drifts from the metal edge into the active region. As such the width of this transition region 21 between the boundary 23 and 24 is not determined by the blocking capability of the edge termination structure.

The highest potential remains spaced apart from the base of the trenches 19 in the active cells 18 and from the surface near the outermost columnar trench 27' of the edge termination structure.

The depletable additional buried doped region 31 is able to locally relax the electric field. As it laterally extends under the outer end 50 of the body region 30 in the transition region 21, an early breakdown at the curvature at the end 50 of the body region 30 is avoided. As it extends laterally towards the side faces of the semiconductor body 12 into the outer region 25 which includes no columnar trenches with field plates, the potential is laterally stretched at the outer side of the termination structure and reduced at the laterally outermost trench 27' of the edge termination region so as to avoid an early breakdown at this location in particular at the surface of the semiconductor body 12 at the laterally outermost trench 27' of the edge termination region 17.

A breakdown location in the inactive transistor cells which are without a body contact are avoided, thus demonstrating that the edge termination structure including the buried doped layer 31 as described herein has the desired effect of avoiding breakdown at the surface in the edge termination region.

To summarize, an edge termination structure for charge-compensated power MOSFET devices using field-plates in needle-shaped trenches is provided that includes a depletable buried counter doped region, for example, a buried p-doped region if the drift region is n-doped, and one or more continuous trenches that are filled with dielectric material in the edge termination region. The continuous dielectric filled trench(es) extend through and interrupt the buried doped region 31. The depletable buried doped region extends laterally under the end of the body region at one side and extends further than the outermost edge termination trench on the other side. The buried doped region is spaced apart from the body region by a portion of the drift region. The vertical overlap between the buried doped region and the body region at one end of the buried doped region and the extension of the buried doped region beyond the outermost edge termination trench provides an edge termination structure that is more insensitive to any surface charges which might be introduced later (as, for example, during assembly) which enhances the robustness and reliability of the device. Therefore, any reduction of the surface doping level in the edge termination region and outside of it is avoided and the sensitivity is significantly reduced to any surface charges which might be introduced.

The combination of the continuous dielectric filled trench and the buried doped region in the edge termination region improves the avalanche ruggedness of the transistor device, since the structure moves avalanche breakdown into the active cell area. As it is not necessary to alter the design of the active transistor cells to provide an effective termination structure, the transistor cell structure can be optimized to achieve better Ron.Area and switching characteristics. As the edge termination structure is small, a larger active area and, therefore, a better Ron.Area is achieved. Additionally, no unnecessary termination capacitance is introduced, thus improving Qoss.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor device (10), comprising:
a semiconductor body (12) comprising an active area (15), wherein the active area (15) comprises a plurality of active transistor cells (18), each active transistor cell (18) comprising a columnar trench (19) comprising a field plate (39) and a mesa (20), and
an edge termination region (17) laterally surrounding the active area (15), wherein the edge termination region (17) comprises:
a transition region (21) laterally surrounding the active region (15) and an outer termination region (22) laterally surrounding the transition region (21),
a plurality of inactive cells (26) arranged in the transition region (21) and in the outer termination region (22), each inactive cell (26) comprising a columnar termination trench (27) comprising a field plate (39) and a termination mesa (28) comprising a drift region (29) of a first conductivity type, wherein, in the transition region (21), the termination mesa (28) comprises a body region (30) of the second conductivity type arranged on the drift region (29) and in the outer termination region (22) the drift region (29) of the termination mesa (28) extends to the first surface (13);
at least one continuous trench (50) that is positioned in the outer termination region (22), laterally surrounds the columnar termination trenches (27) and is filled with at least one dielectric material (51) .

2. A semiconductor device (10) according to claim 1, further comprising a buried doped region (31) of the second conductivity type that has a lateral extent such that it is positioned in the transition region (21) and in the outer termination region (22).

3. A semiconductor device (10) according to claim 2, wherein the buried doped region (31) comprises an inner edge (34) that is positioned under the body region (30) in the transition region (21) and an outer edge (35) that is positioned outside of the continuous trench and the plurality of inactive cells (28) in the outer termination region (22) .

4. A semiconductor device (10) according to any one of claims 1 to 3, wherein, in the transition region (21), the buried doped region (31) is vertically spaced apart from the body region (30) of the termination mesa (28) by a portion of the drift region (29).

5. A semiconductor device (10) according to any one of claims 1 to 4, wherein in the transition region (21) the body region (30) of the termination mesas (28) extends to the first surface (13).

6. A semiconductor device (10) according to any one of claims 1 to 5, wherein the dielectric material (51) comprises portions of differing composition.

7. A semiconductor device (10) according to one of claims 1 to 6, wherein the dielectric material (51) comprises at least one dielectric layer (52) that lines sidewalls (53) and a base (54) of the continuous trench (50).

8. A semiconductor device (10) according to claim 7, wherein the at least one dielectric layer (52) surrounds a gap (55) or an enclosed cavity (58) positioned in the continuous trench (50).

9. A semiconductor device (10) according to claim 7 or claim 8, wherein the dielectric material (51) comprises a first dielectric layer (56) and a second dielectric layer (57) arranged on the first dielectric layer (56).

10. A semiconductor device (10) according to claim 9, wherein the first dielectric layer (56) is thinner than the second dielectric layer (57).

11. A semiconductor device (10) according to claim 9 or claim 10, wherein the first dielectric layer (56) is a thermally grown SiOₓ layer and the second dielectric layer (57) is a TEOS layer.

12. A semiconductor device (10) according to one of claims 1 to 11, wherein the continuous trench (50) is spaced apart from an outermost columnar termination trench (27) by a distance dₒᵤₜₑᵣ and 50 nm ≤ dₒᵤₜₑᵣ ≤ 2 µm.

13. A semiconductor device (10) according to one of claims 1 to 12, wherein each mesa (20) of the active transistor cells (18) comprises a drift region (29) of a first conductivity type, a body region (30) of a second conductivity type opposing the first conductivity type arranged on the drift region (29), a source region (36) of the first conductivity type arranged on the body region (30) and a gate trench (37) comprising a gate electrode (38), wherein the gate trench (37) extends through the source region (36) and the body region (30) into the drift region (29), wherein each of the columnar trenches (19) extends from the first surface (13) through the body region (30) and into the drift region (29).

14. A semiconductor device (10) according to one of claims 1 to 13, further comprising at least one gate finger (40) extending over the edge termination region (17) to a gate runner (41) that is positioned laterally between the side face (14) of the semiconductor body (12) and the continuous trench (50) in the outer termination region (17).

15. A semiconductor device (10) according to claim 14, further comprising a gate contact (44) electrically coupling the gate runner (40) to gate electrodes (38) of the active transistor cells (18), wherein the gate contact (44) is positioned above the body region (30) in the transition region (21).
